Europäisches Patentamt

European Patent Office

Office européen des brevets

(11) Numéro de publication: **0 222 445**
**A1**

(12) # DEMANDE DE BREVET EUROPEEN

(21) Numéro de dépôt: 86201909.8

(22) Date de dépôt: 03.11.86

(51) Int. Cl.4: **H01P 7/08 , H03J 3/18**

(30) Priorité: 05.11.85 FR 8516378

(43) Date de publication de la demande:
20.05.87 Bulletin 87/21

(84) Etats contractants désignés:
DE ES FR GB IT

(71) Demandeur: **LA RADIOTECHNIQUE INDUSTRIELLE ET COMMERCIALE Société Anonyme dite:**
**51, rue Carnot BP 301**
**F-92156 Suresnes(FR) FR**
Demandeur: **N.V. Philips' Gloeilampenfabrieken**
**Groenewoudseweg 1**
**NL-5621 BA Eindhoven(NL) DE ES GB IT**

(72) Inventeur: **Maitre, Thierry SOCIETE CIVILE S.P.I.D.**
**209, rue de l'Université**
**F-75007 - Paris(FR)**

(74) Mandataire: **Caron, Jean et al**
**SOCIETE CIVILE S.P.I.D. 209, rue de l'Université**
**F-75007 Paris(FR)**

(54) Circuit à ligne microbande résonante.

(57) L'invention concerne un dispositif pour le réglage fin d'une ligne microbande résonnante (1) formée sur un substrat isolant (2), accordée par une diode "varicap" (7, 8), permettant d'ajuster la forme de la courbe de fréquence d'accord de la ligne en fonction de la tension continue de commande de la diode.

Selon l'invention, un ou plusieurs trous borgnes sont creusés dans la surface du substrat opposée à la ligne, sous celle-ci, et une pièce mécanique (15) portant un ou plusieurs trous filetés dans lesquels sont vissés des cylindres, est disposée sous la ligne, les cylindres étant placés en regard des trous borgnes et pouvant y pénétrer. Les cylindres et leur support sont électriquement conducteurs et reliés à la masse.

FIG.1

## "CIRCUIT A LIGNE MICROBANDE RESONNANTE".

L'invention concerne un circuit à ligne microbande, disposée sur une face d'un support isolant dont l'autre face porte un plan de masse, ligne utilisée comme élément résonnant d'un circuit actif pour la syntonisation d'un système de réception de télévision par satellite, élément dont la fréquence de résonance peut être modifiée au moyen d'au moins une diode à capacité variable.

Une telle ligne est utilisée notamment comme élément d'accord d'un oscillateur pour des fréquences de l'ordre d'un gigahertz ou plus, dans les systèmes pour la réception de télévision par satellite. Dans ces systèmes, on trouve un élément placé en aval du câble de descente d'antenne, auquel est amené un signal dont la fréquence est comprise entre 950 MHZ et 1,75 GHZ. Cet élément est muni de circuits d'entrée accordés à haute fréquence, suivis d'un étage mélangeur de fréquence comportant un oscillateur local, et fournissant un signal dit à fréquence intermédiaire.

Lorsqu'on procède à la syntonisation de cet élément, on fait varier à la fois le fréquence d'accord des circuits d'entrée et celle de l'oscillateur local. Lors de cette opération il est difficile d'obtenir une variation de fréquence identique pour le circuit d'entrée et pour l'oscillateur local.

Les solutions connues utilisées pour des circuits accordés constitués à partis de condensateurs variables et/ou d'inductances bobinées ne sont pas applicables dans le cas présent, pour les fréquences considérées, puisqu'on utilise un élément résonnant fait d'une ligne microbande, en association avec des diodes à capacité variable. Les dispersions de fabrication de ces diodes sont telles que la variation de fréquence obtenue par une variation donnée de la tension aux bornes de la diode n'est pas suffisamment reproductible pour permettre d'obtenir que la fréquence de l'oscillateur et celle du circuit d'accord haute fréquence se suivent avec une différence constante lorsqu'on fait varier la fréquence. Il est donc nécessaire de prévoir un réglage fin additionnel.

Une solution pour accorder une ligne résonnante est décrite dans la demande de brevet européen EP-A-0 044 941.

Dans ce document est décrit un circuit comportant plusieurs lignes d'adaptation raccordées à une ligne principale. Le problème dont la solution est ainsi divulguée consiste à régler pour chaque ligne sa fréquence d'accord, ce qui est obtenu au moyen de pièces métalliques mobiles constituant des capacités variables placées en bout de la ligne à accorder, capacités dont l'effet sur la longueur apparente de la ligne est bien connu.

Le problème que la présente invention se propose de résoudre n'est pas seulement de régler une ligne pour une fréquence donnée, mais d'obtenir une courbe déterminée de variation de fréquence lorsqu'on fait varier un élément d'accord, notamment la tension de commande d'une diode varicap placée en bout de ligne. Il n'est pas évident que le réglage de capacités constituées par des pièces mobiles selon le document cité puisse résoudre ce problème.

L'invention a pour but de procurer une ligne dont la fréquence d'accord peut être modifiée électriquement au moyen d'un composant variable, notamment d'une diode à capacité variable, et dont on peut ajuster finement la forme de la courbe de variation de fréquence en fonction du paramètre de commande, à savoir de la tension continue de commande dans le cas d'une diode à capacité variable. Cet ajustage de la forme de la courbe doit pouvoir être obtenu par un nombre d'étapes de réglage faible, et être fin, reproductible et stable.

A cet effet, un circuit à ligne selon l'invention est notamment remarquable en ce que, la ligne étant du type demi-onde, raccourcie à chaque extrémité par une diode à capacité variable pour assurer la syntonisation, elle est munie d'un dispositif d'ajustage pour modeler la forme de la courbe de variation de fréquence produite par les diodes à capacité variable, constitué d'au moins une vis située pratiquement au milieu de la ligne du côté du plan de masse, vis dont l'extrémité en matériau électriquement conducteur est reliée à la masse et disposée en regard d'un orifice percé dans le plan de masse, et dont la distance par rapport à la ligne microbande est ajustable.

Le dispositif de réglage selon l'invention a l'avantage d'être peu coûteux, non microphonique, sans crachement lorsqu'on ajuste la susdite distance, actionnable par un outil métallique non isolé et peu sensible à des variations de température.

En outre le support isolant comporte avantageusement un logement creusé dans la face opposée à celle qui porte la ligne, et ladite partie électriquement conductrice peut pénétrer dans ce logement.

Cette disposition permet d'obtenir une plage de réglage plus étendue.

Pour accroître les possibilités de réglage en différents points de la courbe de variation de fréquence, le dispositif comporte avantageusement deux autres dispositifs à vis chacun à une des extrémités de la ligne, les trois vis pouvant être toutes disposées dans un support commun muni de plusieurs trous filetés.

La description qui va suivre, en regard des dessins annexés décrivant des exemples non limitatifs fera bien comprendre comment l'invention peut être réalisée.

La figure 1 est une vue simplifiée, en perspective, d'un circuit à ligne microbande.

La figure 2 est une coupe du dispositif perpendiculairement à l'axe de la ligne.

Pour réaliser un circuit résonnant à des fréquences de l'ordre de deux gigahertz on utilise de préférence une ligne microbande dont l'une des extrémités est en court circuit ou bien en circuit ouvert, réalisée sur un circuit imprimé double face, portant un plan de masse sur une face et la ligne sur l'autre face.

Un oscillateur muni d'un tel circuit résonnant et dont la fréquence doit être réglable, par exemple entre 1.43 et 2,23 gigahertz, comporte soit une ligne quart d'onde "raccourcie" par une capacité variable, soit, une ligne demi-onde raccourcie à chaque extrémité par une capacité variable. Les capacités variables sont constituées par des diodes à capacité variable.

Cet oscillateur est destiné à engendrer une fréquence intermédiaire de 480 MHZ à partir d'une onde reçue qui est comprise entre 950 megahertz et 1,75 gigahertz, et le système est muni à cet effet d'un étage de présélection haute fréquence accordé lui aussi.

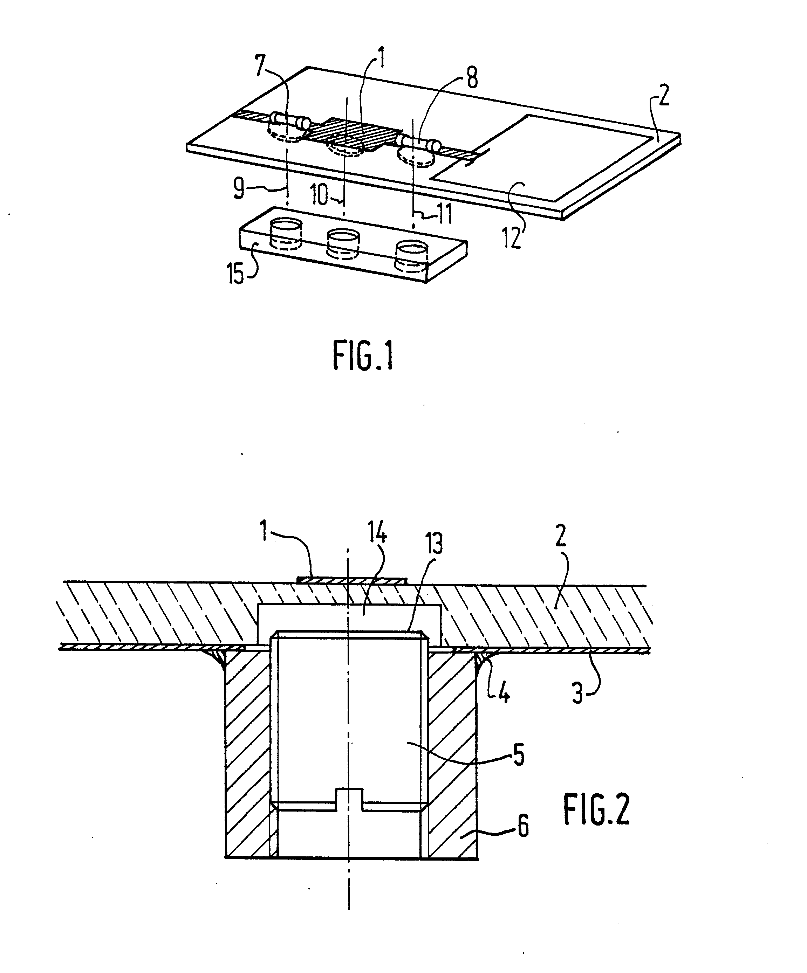

La figure 1 peut aussi bien représenter un tel étage qu'un étage oscillateur. La référence 1 indique une ligne microbande, "raccourcie" par des diodes à capacité variable 7, 8, et disposée sur un substrat de circuit imprimé 2. La partie active, oscillateur ou amplificateur, est indiquée succinctement par un rectangle 12.

Le problème à résoudre est d'assurer que, lorsqu'on fait varier la tension continue de commande de capacité des diodes à capacité variable 7, 8, la fréquence d'accord de la partie présélection d'une part, et celle de l'oscillateur d'autre part, variant ensemble en restant toujours distantes l'une de l'autre de 480 MHZ. A cet effet l'une des deux lignes microbandes, c'est à dire soit celle de l'oscillateur, soit celle de l'étage de présélection HF, représentée sur la figure 2 en coupe perpendiculairement à la ligne microbande 1, est munie d'un dispositif mécanique 4, 5, 6 comportant au moins une vis mobile 5 qui présente au moins une partie électriquement conductrice 13, et le plan de masse 3 présente une solution de continuité placée sous la ligne, en regard de laquelle est placée la partie 13 électriquement conductrice. Les moyens mécaniques 5, 6 permettent d'ajuster finement la distance entre la ligne et la partie conductrice 13. Ces moyens sont constitués par un canon fileté 6 à l'intérieur duquel se déplace une vis 5. Le canon 6 et la vis 5 sont tous deux conducteurs de l'électricité au moins en surface, et le canon est appliqué sur le plan de masse 3, de manière à ce que la section supérieure de la vis 5, section qui est plane et parallèle au plan de masse 3, et donc aussi à la ligne 1, et qui constitue la susdite partie conductrice 13, soit électriquement reliée à la masse. Les deux parties 5 et 6 peuvent par exemple être réalisées par décolletage en laiton massif. Le canon 6 est fixé, par un congé 4 de soudure à l'étain, au plan de masse 3. Ces pièces peuvent aussi être réalisées par moulage en plastique, et métallisées ; elles devront alors être fixées par exemple par "clipsage" au travers du substrat 2. Cette solution très bon marché est cependant d'une qualité médiocre.

Le support 2 isolant comporte un logement 14 creusé dans la face opposée à celle qui porte la ligne 1, et la partie 13 peut pénétrer dans ce logement. Ainsi, il est possible d'obtenir une variation de réglage dans les deux sens, par rapport à la fréquence qui serait obtenue si le plan de masse était présent à cet endroit.

L'analyse théorique des effets provoquée par ce type de réglage est relativement complexe et son exposé n'est pas indispensable à la compréhension de l'invention ; toutefois les résultats de cette analyse sont intéressants. L'analyse s'appuie sur la constatation que le réglage agit seulement sur la capacité de la ligne, et ceci localement. Il modifie donc, sur une partie de la ligne, l'impédance caractéristique et la constante de propagation. Les résultats de cette analyse sont les suivants: la ligne étant utilisée en résonateur n'est pas fermée sur son impédance caractéristique, et le taux d'ondes stationnaires y est volontairement élevé. Dès lors :

-A une fréquence donnée, lorsque le dispositif est placé en un ventre de tension du résonateur, l'action d'enfoncer la vis 5 augmente la longueur électrique de celui-ci et par conséquent diminue la valeur de sa fréquence de résonance.

-A une fréquence donnée, lorsque le dispositif est placé au voisinage d'un noeud de tension du résonateur l'effet de ce-lui-ci est plus complexe :

Si au voisinage de ce noeud de tension, la ligne du résonateur présente un comportement capacitif, l'action d'enfoncer la vis 5 diminue la longueur électrique de celui-ci et par conséquent augmente la valeur de sa fréquence de résonance.

Si au voisinage de ce noeud de tension, la ligne du résonateur présente un comportement inductif, l'action d'enfoncer la vis 5 augmente la longueur électrique de celui-ci et par conséquent diminue la valeur de sa fréquence de résonance.

De ces propriétés résulte que, selon la fréquence, l'action du dispositif est différente. Ainsi avec une ligne qui présente un noeud de tension en son centre pour le milieu de la gamme de fréquences, une vis 5 disposée au centre de la ligne agit dans un sens à une extrémité de la gamme de fréquence, et dans l'autre sens à l'autre extrémité de cette gamme. Il est donc possible de faire basculer en bloc la courbe de fréquences autour de son milieu. Pour obtenir plus de finesse encore dans l'appariement de la courbe du sélecteur haute fréquence et de celle de l'oscillateur, il est avantageux de disposer plusieurs vis indépendantes disposées le long de la longueur de la ligne. Ainsi chacune des vis aura un effet différent, et le réglage global sera facilité. Celui-ci est réalisé de préférence avec emploi d'un modulateur qui affiche toute la courbe de fréquences. Comme chaque vis agit de manière relativement sélective pour une partie de la courbe de réponse, l'ajustage de l'ensemble de la courbe est obtenu rapidement, sans avoir à retoucher un grand nombre de fois chaque vis 5.

La pluralité de vis 5 est avantageusement disposée dans un support commun unique, muni de plusieurs trous filetés. La figure 1 montre un tel support commun 15 muni de trois trous d'axes respectivement 9, 10, 11. Ce support 15 est représenté en dessous du substrat 2, pour la clarté de la figure, mais il est bien évident qu'il doit être monté appliqué contre le plan de masse sous le substrat 2.

. A chaque extrémité de la ligne se trouve un composant, à savoir une diode à capacité variable 7, 8 et les axes 9 et 11 passent pratiquement par les centres des boîtiers des diodes respectivement 7 et 8. Les dispositifs à vis corresponants sont donc placés sous les diodes.

## Revendications

1. Circuit à ligne microbande disposée sur une face d'un support isolant dont l'autre face porte un plan de masse, ligne utilisée comme élément résonnant d'un circuit actif pour la syntonisation d'un système de réception de télévision par satellite, élément dont la fréquence de résonance peut être modifiée au moyen d'au moins une diode à capacité variable, caractérisé en ce que, la ligne étant du type demi-onde, raccourcie à chaque extrémité par une diode à capacité variable pour assurer la syntonisation, elle est munie d'un dispositif d'ajustage pour modeler la forme de la courbe de variation de fréquence produite par les diodes à capacité variable, constitué d'au moins une vis située pratiquement au milieu de la ligne du côté du plan de masse, vis dont l'extrémité en matériau électriquement conducteur est reliée à la masse et disposée en regard d'un orifice percé dans le plan de masse, et dont la distance par rapport à la ligne microbande est ajustable.

2. Circuit selon la revendication 1, caractérisé en ce que le support isolant comporte un logement creusé dans la face opposée à celle qui porte la ligne, et en ce que ladite partie électriquement conductrice peut pénétrer dans ce logement.

. 3. Circuit selon l'une des revendications 1 ou 2, caractérisé en ce que le dispositif mécanique comporte deux autres dispositifs à vis chacun à une des extrémités de la ligne.

4. Circuit selon la revendication 3, caractérisé en ce que le deux dispositifs sont placés chacun sous une diode à capacité variable.

5. Circuit selon l'une des revendications 3 ou 4, caractérisé en ce que les trois vis sont toutes disposées dans un support commun muni de plusieurs trous filetés.

FIG.1

FIG.2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.⁴) |
|---|---|---|---|
| Y | GB-A-2 027 299  (LICENTIA PATENT) <br> * En entier * | 1,2 | H 01 P    7/08 <br> H 03 J    3/18 |
| Y | EP-A-0 117 178  (THOMSON-CSF) <br> * Page 4, ligne 5 - page 5, ligne 9; figures 1-3 * | 1,2 | |
| A | US-A-3 639 857  (T. OKOSHI et al.) <br> * Colonne 3, lignes 20-41; figure 5 * | 1,2 | |
| A | GB-A-1 232 520  (STANDARD TELEPHONES) <br> *  Page  2,  ligne  85  - page 3, ligne 21; figures 4,5 * | 3,5 | DOMAINES TECHNIQUES RECHERCHES (Int. Cl.⁴) |
| A | EP-A-0 044 941  (LICENTIA PATENT) <br> * Résumé;  page  2,  lignes  1-6; figures 1-3 * | 3,5 | H 01 P <br> H 03 J |
| A | US-A-3 530 411  (B.E. SEAR) <br> * En entier * | 2,3,5 | |
| A | US-A-3 925 740  (P.D. STEESMA) <br> * En entier * | 3,5 | |

Le present rapport de recherche a été établi pour toutes les revendications

| Lieu de la recherche | Date d'achevement de la recherche | Examinateur |
|---|---|---|
| LA HAYE | 27-01-1987 | LAUGEL R.M.L. |